# FASCICULE DE BREVET EUROPEEN

(11) **EP 1 038 670 B1**
(45) Date de publication et mention de la délivrance du brevet: **21.08.2013**
(21) Numéro de dépôt: 00400822.3
(22) Date de dépôt: 24.03.2000
(51) Int. Cl.: B41C 1/18, B41F 17/00

(54) **Procédé de réalisation d'une bande d'impression en relief à base de photopolymères**
Verfahren zur Herstellung eines photopolymeren Druckbands für den Flexodruck
Process for making a photopolymer relief printing belt

(30) Priorité: 26.03.1999 FR 9903827
(43) Date de publication de la demande: 27.09.2000
(73) Titulaire: MACDERMID PRINTING SOLUTIONS EUROPE SAS, 68700 Cernay (FR)
(72) Inventeur: Korchak, Tom, 68500 Jungholtz (FR); Barral, Christian, 68700 Uffholtz (FR); Bertrand, Dominique, 89190 Bagneaux (FR)
(74) Mandataire: Thinat, Michel

(56) Documents cités:
- EP-A- 0 308 367
- EP-A- 0 598 926
- US-A- 4 197 126

## Description

L'invention concerne un procédé de réalisation d'une bande d'impression en relief à base de photopolymères, telle qu'une bande d'impression dite typographique ou flexographique, selon le préambule de la revendication 1.

Un procédé de ce type est décrit dans le brevet européen EP 0 308 367. Ce document enseigne la réalisation des plaques d'impression directement sur le support porteur de la couche de photopolymères par projection d'un liquide de recouvrement sur les zones dans lesquelles le photopolymère ne doit pas être réticulé pour pouvoir ensuite être enlevé.

Le document EP 308 367 décrit un procédé qui utilise un support sous forme d'une bande sans fin sur laquelle sont fixées par collage des plaques d'impression flexibles.

Par ailleurs une bande d'impression flexographique ou typographique est classiquement obtenue en réalisant tout d'abord des négatifs pour chaque page à imprimer, puis en réalisant des plaques d'impression pour chaque page en utilisant les négatifs et enfin, en montant les plaques d'impression en registre sur une bande relativement rigide, par exemple à l'aide d'adhésifs double face. La bande d'impression ainsi obtenue est soumise à un contrôle.

L'obtention d'une bande d'impression typographique ou flexographique nécessite donc la mise en oeuvre d'un procédé long et coûteux, une série d'opérations spécifiques étant nécessaire pour réaliser chaque plaque d'impression correspondant à une page à imprimer. En particulier, un négatif ou un masque individuel doit être réalisé pour chaque plaque d'impression.

De plus, des erreurs de montage ou de registre peuvent survenir lors du montage des plaques d'impression sur la bande sans fin. Il peut notamment s'agir d'erreurs de positionnement de chaque plaque d'impression par rapport aux autres ainsi que de décalage entre les pages. Ces erreurs sont possibles et fréquentes car une bande d'impression flexographique ou typographique comporte une quantité importante de plaques d'impression. De plus, le montage des plaques d'impression n'est pas simple car l'agencement des plaques doit tenir compte des plis successifs du support de papier imprimé en cahiers avant brochage du livre.

Ces erreurs de montage ou de registre des plaques d'impression ne peuvent être détectées qu'au démarrage de l'impression. Il convient alors de corriger le montage des plaques d'impression, ce qui conduit à une perte de temps d'utilisation de la machine à imprimer.

Enfin, la fixation des plaques d'impression individuelles sur la bande sans fin n'est pas totalement sûre. Certaines d'entre elles peuvent se décoller de la bande lors de l'impression, ce qui entraîne une perte de bandes de papier imprimées ainsi qu'une perte de temps d'utilisation de la machine à imprimer, lors de la réparation de la bande d'impression flexographique.

L'invention a pour but de pallier les inconvénients de l'état de la technique.

Pour atteindre ce but, le procédé selon l'invention comporte les caractéristiques qui sont exposées dans la partie caractérisante de la revendication 1.

L'invention concerne également un dispositif pour la mise en oeuvre du procédé, qui comporte les caractéristiques énoncées dans la revendication 16.

D'autres caractéristiques avantageuses du procédé et du dispositif selon l'invention font l'objet de revendications dépendantes.

L'invention sera mieux comprise et d'autres buts, avantages et caractéristiques de celle-c apparaîtront plus clairement à la lecture de la description qui suit et qui est faite au regard de la figure unique annexée qui illustre un exemple de dispositif selon l'invention pour l'obtention d'une bande d'impression flexographique.

La figure montre schématiquement un support sans fin 1, relativement rigide, mis en place sur deux cylindres 2a et 2b, espacés l'un de l'autre.

Le support 1 peut notamment être réalisé en polyester, en polycarbonate ou en un matériau analogue.

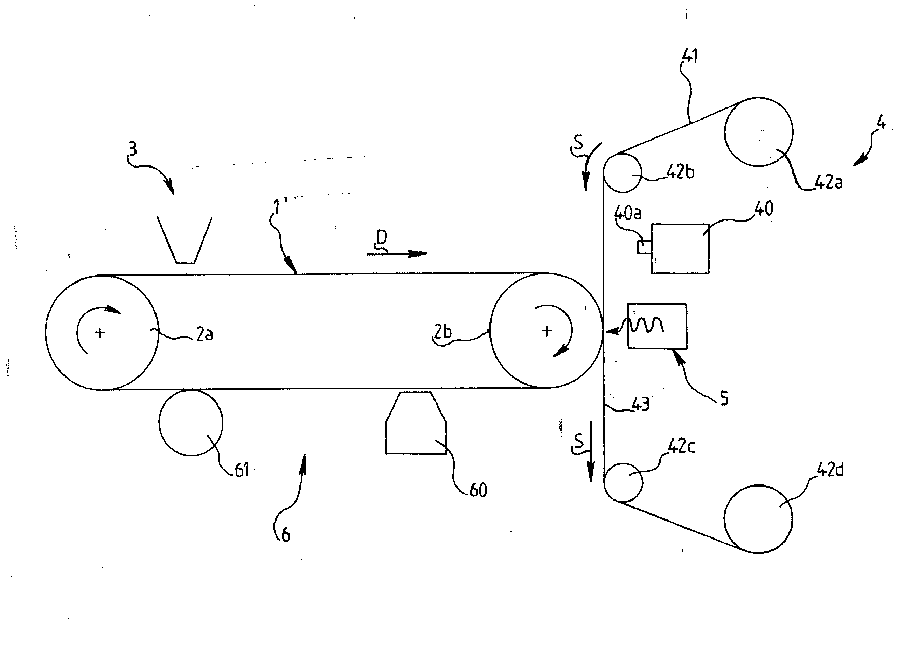

De façon avantageuse, le support 1 est transparent aux UV pour permettre une exposition dorsale aux UV d'une couche de photopolymère déposée sur le support. Le dispositif associé n'est pas représenté mais peut être placé à un endroit approprié du dispositif illustré à la figure 1, notamment à l'intérieur de l'espace délimité par le support. Ainsi, lorsque le support aura reçu une couche de photopolymère, l'exposition dorsale aux UV du support 1 permettra de réaliser une sous-couche de photopolymère complètement réticulée.

Le dispositif selon l'invention comporte également des moyens d'entraînement en rotation des deux cylindres 2a et 2b qui ne sont pas illustrés sur la figure. Le mouvement de rotation des deux cylindres permet d'entraîner le support 1 dans le sens de défilement illustré par la flèche D.

Les dimensions suivantes peuvent être retenues pour le support 1, dimensions qui s'appliqueront également à la bande d'impression flexographique obtenue à partir de ce support : le développement peut être compris entre 1 et 20 mètres et la largeur est inférieure ou égale à 2 mètres. L'épaisseur du support est comprise entre 0.1 et 0.5 millimètres.

Le dispositif selon l'invention comporte des moyens 3 pour l'application d'un photopolymère sur la surface du support 1. Les moyens applicateurs 3 sont fixes et le photopolymère est appliqué sur l'ensemble du support 1 du fait du déplacement du support 1 par rapport aux moyens applicateur 3. Ces moyens applicateurs sont d'une conception classique et ne seront pas décrits plus en détail.

Une couche constituant un primaire d'accrochage sur le support 1 de la couche de photopolymère peut être appliquée sur la surface externe du support 1 par tout moyen approprié et connu en soi.

Le photopolymère utilisé peut être un photopolymère positif, c'est-à-dire un polymère dont la réticulation se produit par exposition à la lumière, notamment UV, ou encore un polymère négatif, c'est-à-dire un polymère qui se dégrade sous irradiation.

Par ailleurs, les moyens applicateurs 3 peuvent être conçus pour un photopolymère liquide, ou encore un photopolymère solide, extrudé au préalable sur une bande sans fin ou un manchon.

Le photopolymère utilisé présente, de préférence, une dureté comprise entre 20 et 85 ShA.

Le dispositif comprend également des moyens 4 pour réaliser un masque permettant d'obtenir l'ensemble des plaques d'impression que doit comprendre la bande d'impression flexographique finale.

Ces moyens 4 comportent, dans cet exemple de réalisation, un dispositif 40 de type à jet d'encre qui applique par pulvérisation un liquide de recouvrement, au moyen d'au moins une buse 40a, sur un substrat 41.

Le substrat 41 est supporté et entraîné en rotation par un ensemble de quatre cylindres 42a, 42b, 42c et 42d, les moyens d'entraînement en rotation des cylindres n'étant pas illustrés la figure.

Le trajet du substrat 41 est illustré par les flèches S.

Ainsi, le dispositif 40 à jet d'encre recouvre la surface du substrat 41 d'un motif déterminé. Le substrat peut notamment être réalisé en un matériau du type polyéthylène ou polypropylène.

Le dispositif comporte également des moyens 5 permettant d'exposer le support 1 à la lumière UV, à travers le substrat 41 comportant le motif appliqué par le dispositif à jet d'encre 40.

Le dispositif comprend des moyens pour imprimer un mouvement synchronisé entre le support 1 et le substrat 41, de telle sorte que le masque 43 est réalisé en continu sur le substrat 41 par le dispositif à jet d'encre 40, les plaques d'impression étant directement réalisées sur le support 1, par irradiation UV, également en continu et au fur et à mesure de la réalisation du masque 43 sur le substrat 41.

Ainsi, les moyens 4 permettent de réaliser un masque sur un substrat unique et qui permet d'obtenir l'ensemble des plaques d'impression que doit comporter la bande d'impression flexographique finale.

Ainsi, en mettant en oeuvre le procédé selon l'invention grâce au dispositif décrit sur la figure, il n'est plus nécessaire de réaliser de façon individuelle un masque pour chaque plaque d'impression, le procédé selon l'invention consistant à réaliser un masque unique 43 pour toutes les plaques d'impression.

Par ailleurs, le dispositif à jet d'encre 40 peut avantageusement être piloté par des moyens numériques pour rendre plus rapide la réalisation du masque sur le substrat 41 et améliorer la qualité de l'impression.

Le dispositif 40 est, de façon préférée, associé à des moyens de contrôle pour que le masque soit réalisé sur le substrat 41 en évitant toute erreur d'inversion ou de décalage.

Par ailleurs, les plaques d'impression sont obtenues directement sur le support 1, par insolation à travers le masque, toute opération de montage de plaques d'impression étant ainsi éliminée et, avec elle, tout risque d'erreurs de positionnement des plaques.

Le dispositif selon l'invention comporte également des moyens 6 pour l'élimination du photopolymère non réticulé, après exposition du support 1 à travers le masque 43.

Dans l'exemple représenté ici, ces moyens d'élimination du photopolymère non réticulé conviennent à un photopolymère liquide et comprennent un système 60 générant une lame d'air et un système absorbant 61.

Un procédé d'élimination de photopolymère non réticulé utilisant des systèmes de ce type est notamment décrit dans le document US-4 197 126. Le procédé de récupération de polymère liquide non réticulé décrit dans ce document s'applique à une plaque d'impression.

Le procédé selon l'invention qui peut notamment être mis en oeuvre avec le dispositif illustré sur la figure, comporte avantageusement une étape finale de finition et de contrôle.

L'étape de finition consiste à réaliser une post-cuisson pour obtenir les performances nominales du photopolymère, tandis que l'étape de contrôle consiste à vérifier la qualité de l'image reproduite sur la bande d'impression.

Après cette étape finale, la bande obtenue par le procédé selon l'invention peut être transférée ultérieurement sur une machine à imprimer.

L'épaisseur totale maximale de la bande obtenue est comprise entre 0.75 et 3mm.

Le dispositif qui vient d'être décrit permet de réaliser un masque, indépendamment du support 1. Ce masque peut ainsi être récupéré pour un usage ultérieur, comme la fabrication de plaques d'impression individuelles, ou encore pour une réalisation d'épreuves.

Selon une variante de mise en oeuvre du procédé selon l'invention, le masque peut être appliqué sous tension sur le support 1, sur une longueur déterminée de ce support. Cette application sous tension permet d'éviter les phénomènes d'inhibition par l'oxygène, lors de l'insolation UV.

Cette tension peut être obtenue par un dispositif particulier annexe ou encore par l'intermédiaire d'une bande supplémentaire transparente aux UV.

Il convient de noter que cette application sous tension du masque ne modifie pas le mode de réalisation de celui-ci, lequel est commun à toutes les plaques d'impression souhaitées, et n'a donc rien à voir avec la fixation de plaques d'impression individuelles sur un support.

Enfin, le support 1 peut également comporter une couche en un matériau compressible, sur laquelle le photopolymère sera déposé par les moyens 3. Cette couche en matériau compressible permet de mieux contrôler la pression d'impression et donc d'augmenter la qualité d'impression.

Le support 1 peut également comporter une première couche en un matériau photopolymère, sur laquelle sera appliqué un autre matériau photopolymère grâce aux moyens 3. Ces deux matériaux photopolymères sont choisis de façon à présenter des caractéristiques physiques différentes, telles que la dureté, la photosensibilité, la viscosité ou la couleur. Ces deux couches superposées de matériaux photopolymères différents permettent d'obtenir un effet similaire à celui obtenu avec une couche compressible.

Il est bien entendu que l'invention n'est pas limitée à un procédé mis en oeuvre avec le dispositif qui a été décrit sur la figure.

En particulier, le procédé selon l'invention peut consister à réaliser directement le masque sur le support 1 recouvert du photopolymère. Dans ce cas, le substrat 41 sur lequel est réalisé le masque n'est pas utilisé.

L'obtention d'un masque directement sur le support 1 recouvert du photopolymère peut être obtenu par différents procédés.

On peut notamment citer le procédé décrit dans le document EP-0 598 926. Ce procédé est destiné à la fabrication de plaques d'impression flexographique mais il peut être appliqué directement sur le support sans fin 1.

Il s'agit d'un procédé de type jet d'encre qui consiste à appliquer par pulvérisation un liquide de recouvrement sur une couche en photopolymère, pour recouvrir cette surface d'un motif.

Le masque est donc déjà présent sur le support 1 qui peut être ensuite illuminé pour réticuler par illumination les zones qui n'ont pas été recouvertes par le motif, les zones non illuminées de la couche en photopolymère étant enfin éliminées par lavage.

On peut encore citer le document EP-0 741 335 qui décrit un procédé de réalisation d'une plaque d'impression flexographique dans lequel le masque est réalisé directement sur un support par ablation laser.

Ce procédé peut également être appliqué au support sans fin 1, celui-ci étant recouvert d'une couche photopolymérisable puis d'une autre couche opaque aux ultra-violets. Le masque est obtenu en faisant disparaître l'image dans la couche opaque aux UV, sans affecter la couche inférieure en matériau photopolymérisable.

Une fois ce masque obtenu, le support est exposé à une radiation UV à travers le masque, ce qui permet de polymériser la couche photopolymérisable selon l'image, le reste de la couche opaque ainsi que le photopolymère non réticulé étant ensuite éliminés.

On peut également citer un procédé permettant une écriture directe par laser, tel que décrit dans le document EP-0 785 474 auquel on peut se référer. Ce procédé utilise une résine photosensible dans une bande de fréquence différente de l'insolation UV à travers le masque.

Enfin, le masque peut également être obtenu par réticulation directe au moyen de lumière UV modulée en amplitude par des moyens adressables de façon digitale.

La description qui précède a été faite pour une bande d'impression flexographique mais l'invention n'est pas limitée à cette application et concerne toute bande d'impression en relief à base de photopolymères, et notamment les bandes d'impression dites typographiques.

## Revendications

1. Procédé de réalisation d'une bande d'impression en relief à base de photopolymères, telle qu'une bande d'impression dite typographique ou flexographique comportant des plaques d'impression dans un assemblage déterminé, **caractérisé en ce qu'**il consiste à :
mettre en place un support sans fin (1) relativement rigide,
appliquer une couche de photopolymère sur la surface dudit support,
réaliser un masque (43) correspondant à l'ensemble desdites plaques d'impression selon ledit assemblage,
positionner ledit masque (43) par rapport audit support (1),
exposer à la lumière, en particulier UV, la surface dudit support recouvert de photopolymère à travers ledit masque, de telle sorte que lesdites plaques d'impression sont réalisées directement sur ledit support et
à éliminer de la surface dudit support le photopolymère non réticulé,
dans ledit procédé ledit masque (43) est réalisé indépendamment du support et est tendu sur le support (1) lors de l'exposition à la lumière.

2. Procédé selon la revendication 1, **caractérisé en ce que** l'on réalise le masque en appliquant un motif de masque sur un substrat (41).

3. Procédé selon la revendication 2, **caractérisé en ce que** l'on réalise le motif sur le substrat (41) à l'aide d'un dispositif du type à jet d'encre (40).

4. Procédé selon la revendication 3, **caractérisé en ce que** le substrat (41) est en forme d'une bande supportée et entraînée en rotation par un ensemble de cylindres rotatifs (42a, 42b, 42c, 42d).

5. Procédé selon la revendication 4, **caractérisé en ce que** le substrat est réalisé en un matériau du type polyéthylène ou polypropylène.

6. Procédé selon l'une des revendications 2 à 5, **caractérisé en ce que** l'on imprime au substrat (41) un mouvement synchronisé avec le support (1) et réalise le masque (43) en continu sur le substrat (41) par le dispositif à jet d'encre (40), les plaques d'impression étant réalisées sur le support (1) par l'irradiation en continu et au fur et à mesure de la réalisation du masque (43) sur le substrat (41).

7. Procédé selon l'une des revendications 1 à 6, **caractérisé en ce que** le photopolymère appliqué sur la surface du support (1) est liquide.

8. Procédé selon l'une des revendications 1 à 6, **caractérisé en ce que** le photopolymère appliqué sur la surface du support (1) est solide, extrudé au préalable.

9. Procédé selon l'une des revendications 1 à 8, **caractérisé en ce que** le photopolymère est positif.

10. Procédé selon l'une des revendications 1 à 8, **caractérisé en ce que** le photopolymère est négatif.

11. Procédé selon l'une des revendications 1 à 10, **caractérisé en ce qu'**il consiste à disposer au préalable sur le support (1) une couche compressible ou une couche en un autre photopolymère présentant des caractéristiques différentes du photopolymère qui sera appliqué ultérieurement.

12. Procédé selon l'une des revendications 1 à 11, **caractérisé en ce qu'**après exposition à la lumière, l'élimination de la surface du support, du photopolymère non réticulé, est réalisée par exposition à la surface du support à une lame d'air puis par absorption du photopolymère.

13. Procédé selon l'une des revendications 1 à 12, **caractérisé en ce qu'**il comprend une étape finale de finition et de contrôle.

14. Procédé selon l'une des revendications 1 à 13, **caractérisé en ce que** le support est en polyester ou polycarbonate.

15. Procédé selon l'une des revendications 1 à 14, **caractérisé en ce que** la bande d'impression a un développement est compris entre 1 et 20 mètres, la largeur est inférieure ou égale à 2 mètres et l'épaisseur est comprise entre 0,75 et 3 mm.

16. Dispositif pour la mise en oeuvre du procédé selon l'une des revendications 1 à 15, et l'obtention d'une bande d'impression en relief à base de photopolymères, telle qu'une bande d'impression dite typographique ou flexographique comportant :
des plaques d'impression dans un assemblage déterminé, comprenant :- des moyens (4) de réalisation d'un masque (43) correspondant à l'ensemble des plaques d'mpression selon ledit assemblage,
des moyens (42a, 42b, 42c, 42d) pour positionner ledit masque (43) par rapport à un support sans fin (1) recouvert d'une couche de photopolymère,
des moyens (5) pour exposer à la lumière, notamment UV, ledit support à travers ledit masque,
dans lequel ledit masque (43) est réalisé indépendamment du support et est tendu sur le support (1) lors de l'exposition à la lumière, et
des moyens pour éliminer de la surface dudit support le photopolymère non reticulé,
le dispositif comportant des moyens pour fournir un mouvement synchronisé entre les moyens (4) de réalisation du masque et ledit support sans fin (1), de façon à ce que les plaques d'impression soient réalisées directement sur le support, au fur et à mesure de la réalisation du masque (43).

17. Dispositif selon la revendication 16, **caractérisé en ce que** les moyens de réalisation du masque sont du type numérique.

18. Dispositif selon l'une des revendications 16 ou 17, **caractérisé en ce qu'**il comprend un système (60) générant une lame d'air et un système absorbant (61) pour éliminer le photopolymère liquide non réticulé de la surface du support (1).

## Patentansprüche

1. Verfahren zur Herstellung eines Reliefdruckbandes auf Photopolymerbasis, z.B. eines sog. typographischen oder flexographischen Druckbandes, das Druckplatten in einer bestimmten Baugruppe aufweist, **dadurch gekennzeichnet**, das es aus den nachfolgenden Schritten besteht:
Positionieren eines relativ starren endlosen Trägers (1) ,
Auftragen einer Photopolymerschicht auf die Oberfläche des Trägers,
Bilden einer der Baugruppe der Druckplatten entsprechenden Maske (43) gemäß der Baugruppe;
Belichten, insbesondere mit UV-Licht, der mit dem Photopolymeren beschichteten Oberfläche des Trägers durch die Maske, so dass die Druckplatten direkt auf dem Träger realisiert werden; und
Entfernen des nicht vernetzten Photopolymeren von der Trägeroberfläche;
in diesem Verfahren wird die Maske (43) unabhängig vom Träger gebildet und stützt sich bei der Belichtung auf den Träger (1) ab.

2. Verfahren nach Anspruch 1, **dadurch gekennzeichnet, dass** die Maske durch Auftragen eines Maskenmotivs auf ein Substrat (41) gebildet wird.

3. Verfahren nach Anspruch 2, **dadurch gekennzeichnet, dass** das Motiv unter Zuhilfenahme einer Tintenstrahlvorrichtung (40) auf das Substrat (41) aufgetragen wird.

4. Verfahren nach Anspruch 3, **dadurch gekennzeichnet, dass** das Substrat (41) in Form eines von einer Gruppe von Drehzylindern (42a, 42b, 42c, 42d) getragenen und gedrehten Streifens vorliegt.

5. Verfahren nach Anspruch 4, **dadurch gekennzeichnet, dass** das Substrat aus einem Material wie Polyethylen oder Polypropylen ist.

6. Verfahren nach einem der Ansprüche 2 bis 5, **dadurch gekennzeichnet, dass** auf dem Substrat (41) gleichzeitig mit dem Träger (1) gedruckt wird, und dass die Maske (43) auf dem Substrat (41) durch die Tintenstrahlvorrichtung (40) kontinuierlich gebildet wird, wobei die Druckplatten auf dem Träger (1) durch kontinuierliche Belichtung und im Rhythmus der Bildung der Maske (43) auf dem Substrat (41) realisiert werden.

7. Verfahren nach einem der Ansprüche 1 bis 6, **dadurch gekennzeichnet, dass** das auf der Oberfläche des Trägers (1) aufgetragene Photopolymer flüssig ist.

8. Verfahren nach einem der Ansprüche 1 bis 6, **dadurch gekennzeichnet, dass** das auf der Oberfläche des Trägers (1) aufgetragene Photopolymer fest ist und vorher extrudiert wurde.

9. Verfahren nach einem der Ansprüche 1 bis 8, **dadurch gekennzeichnet, dass** das Photopolymer positiv ist.

10. Verfahren nach einem der Ansprüche 1 bis 8, **dadurch gekennzeichnet, dass** das Photopolymer negativ ist.

11. Verfahren nach einem der Ansprüche 1 bis 10, **dadurch gekennzeichnet, dass** es daraus besteht, auf den Träger (1) im Voraus eine komprimierbare Schicht oder eine Schicht aus einem anderen Photopolymeren mit anderen Eigenschaften als das später aufzutragende Photopolymer aufzutragen.

12. Verfahren nach einem der Ansprüche 1 bis 11, **dadurch gekennzeichnet, dass** nach der Belichtung das nicht vernetzte Photopolymer von der Trägeroberfläche dadurch entfernt wird, dass die Trägeroberfläche mit einem Luftmesser bearbeitet und das Photopolymer anschließend absorbiert wird.

13. Verfahren nach einem der Ansprüche 1 bis 12, **dadurch gekennzeichnet, dass** es einen letzten Endbearbeitungs- und Kontrollschritt umfasst.

14. Verfahren nach einem der Ansprüche 1 bis 13, **dadurch gekennzeichnet, dass** der Träger aus Polyester oder Polycarbonat ist.

15. Verfahren nach einem der Ansprüche 1 bis 14, **dadurch gekennzeichnet, dass** das Druckband eine Entwicklung zwischen 1 und 20 m aufweist, die Länge kleiner oder gleich 2 m ist, und die Stärke zwischen 0,75 und 3 mm liegt.

16. Vorrichtung zur Ausführung des Verfahrens nach einem der Ansprüche 1 bis 15 sowie zur Gewinnung eines Reliefdruckbandes auf Photopolymerbasis, z.B. eines sog. typographischen oder flexographischen Druckbandes, aufweisend:
Druckplatten in einer bestimmten Baugruppe, die Mittel (4) zur Bildung einer der Baugruppe der Druckplatten gemäß der Baugruppe entsprechenden Maske (43);
Mittel (42a, 42b, 42c, 42d) zur Positionierung der Maske (43) relativ zu einem mit einer Photopolymerschicht beschichteten endlosen Träger (1);
Mittel (5) zur Belichtung des Trägers durch die Maske, insbesondere mit UV-Licht;
wobei die Maske (43) unabhängig vom Träger gebildet wird und sich bei der Belichtung auf den Träger (1) abstützt; und
Mittel zur Entfernung des nicht vernetzten Photopolymeren von der Oberfläche des Trägers
wobei die Vorrichtung Mittel zur Gewährleistung einer gleichzeitigen Bewegung der Mittel (4) zur Bildung der Maske und des endlosen Trägers (1) aufweist, so dass die Druckplatten direkt auf dem Träger im Rhythmus der Bildung der Maske (43) realisiert werden.

17. Vorrichtung nach Anspruch 16, **dadurch gekennzeichnet, dass** die Mittel zur Bildung der Maske digital sind.

18. Vorrichtung nach einem der Ansprüche 16 oder 17, **dadurch gekennzeichnet, dass** sie ein System (60) umfasst, das ein Luftmesser erzeugt, sowie ein Absorptionssystem (61) zur Entfernung des nicht vernetzten flüssigen Photopolymeren von der Oberfläche des Trägers (1) umfasst.

## Claims

1. A process for forming a photopolymer relief printing belt, such as a so-called typographic or flexographic printing belt comprising printing plates in a determined assembly, **characterized in that** it consists of:
- placing in position a relatively rigid endless carrier (1) ;
- applying a photopolymer layer to the surface of said carrier;
- forming a mask (43) corresponding to all said printing plates corresponding to the said assembly;
- positioning said mask (43) relative to said carrier (1);
- exposing the surface of said carrier coated with photopolymer to light, in particular UV light, through the said mask so that said printing plates are formed directly on said carrier; and
- removing non-cross-linked photopolymer from the surface of said carrier;
in said process the said mask (43) is formed independently of the carrier and is stretched across the carrier (1) at the time of the exposure to light.

2. The process according to claim 1, **characterized in that** the mask is formed by applying a mask pattern to a substrate (41).

3. The process according to claim 2, **characterized in that** the pattern is formed on the substrate (41) using a device of inkjet type (40).

4. The process according to claim 3, **characterized in that** the substrate (41) is in the form of a belt carried and driven in rotation by a set of rotating rolls (42a, 42b, 42c, 42d).

5. The process according to claim 4, **characterized in that** the substrate is made in a material of polyethylene or polypropylene type.

6. The process according to one of claims 2 to 5, **characterized in that** a movement is imparted to the substrate (41) that is synchronized with the carrier (1) and forms the mask (43) continuously on the substrate (41) with the inkjet device (40), the printing plates being formed on the carrier (1) by continuous irradiation as and when the mask (43) is formed on the substrate (41).

7. The process according to one of claims 1 to 6, **characterized in that** the photopolymer applied to the surface of the carrier (1) is liquid.

8. The process according to one of claims 1 to 6, **characterized in that** the photopolymer applied to the surface of the carrier (1) is solid, previously extruded.

9. The process according to one of claims 1 to 8, **characterized in that** the photopolymer is positive.

10. The process according to one of claims 1 to 8, **characterized in that** the photopolymer is negative.

11. The process according to one of claims 1 to 10, **characterized in that** it consists of previously arranging on the carrier (1) a compressible layer or a layer in another photopolymer having characteristics different from those of the photopolymer which is subsequently applied.

12. The process according to one of claims 1 to 11, **characterized in that** after exposure to light, the removal of non-cross-linked photopolymer from the surface of the carrier is performed by exposure of the surface of the carrier to an air-knife followed by absorption of the photopolymer.

13. The process according to one of claims 1 to 12, **characterized in that** it comprises a final completion and inspection step.

14. The process according to one of claims 1 to 13, **characterized in that** the carrier is in polyester or polycarbonate.

15. The process according to one of claims 1 to 14, **characterized in that** the development of the printing belt is between 1 and 20 metres, the width is 2 metres or less, and the thickness is between 0.75 and 3 mm.

16. A device for implementing the process according to one of claims 1 to 15, and for obtaining a photopolymer relief printing belt such as a so-called typographic or flexographic printing belt comprising:
- printing plates assembled in a determined manner comprising means (4) for forming a mask (43) corresponding to all the printing plates as per said assembly:
- means (42a, 42b, 42c, 42d) for positioning said mask (43) relative to an endless carrier (1) coated with a photopolymer layer;
- means (5) for exposing said carrier to light, in particular UV light, through said mask;
- wherein said mask (43) is formed independently of the carrier and is stretched over the carrier (1) at the time of exposure to light; and
- means for removing non-cross-linked photopolymer from the surface of said carrier;
the device comprising means for imparting a synchronized movement between the means (4) for forming the mask and said endless carrier (1), so that the printing plates are formed directly on the carrier as and when the mask (43) is formed.

17. The device according to claim 16, **characterized in that** the means for forming the mask are of digital type.

18. The device according to one of claims 16 or 17, **characterized in that** it comprises a system (60) generating an air knife and an absorbent system (61) to remove non-cross-linked liquid photopolymer from the surface of the carrier (1).
